# EUROPÄISCHE PATENTSCHRIFT

(11) **EP 0 842 995 B1**
(45) Veröffentlichungstag und Bekanntmachung des Hinweises auf die Patenterteilung: **28.04.1999**
(21) Anmeldenummer: 96118502.2
(22) Anmeldetag: 19.11.1996
(51) Int. Cl.: C09J 7/00, C09J 7/02, C09J 5/06, H05K 3/00, H01L 21/58, G06K 19/077, C09J 175/04

(54) **Thermoplastische Klebstofffolie**
Thermoplastic adhesive
Adhésif thermoplastique

(43) Veröffentlichungstag der Anmeldung: 20.05.1998
(73) Patentinhaber: Beiersdorf Aktiengesellschaft, 20245 Hamburg (DE)
(72) Erfinder: Engeldinger, Hans-Karl, 25451 Quickborn (DE); Saucke, Albert-Ralf, 24632 Heidmoor (DE)

(56) Entgegenhaltungen:
- EP-A- 0 334 733
- DE-A-19 519 499
- JP-A- 8 250 522
- US-A- 5 514 240
- PATENT ABSTRACTS OF JAPAN vol. 017, no. 528 (E-1437), 22.September 1993 & JP 05 144855 A (TOSHIBA CHEM CORP), 11.Juni 1993,

## Beschreibung

Die Erfindung beschreibt eine thermoplastische Klebstoffolie, wie sie zum Implantieren von elektrischen Modulen in einen Kartenkörper unter Einwirkung von Druck und Wärme verwendet wird. Der fertig verklebte Verbund wird als "Chipkarte" oder "Smart Card" bezeichnet.

Datenträger mit integriertem Schaltkreis sind bekannt und weit verbreitet, z. B. als Telefonkarten, Identifikationskarten, Bankkarten o. a. Die Trägerelemente für die Chips-auch Module genannt - werden in die entsprechend dimensionierten Aushöhlungen des Kartenkörpers maschinell in schneller Folge implantiert. Zur Fixierung dient dabei ein Klebsystem.

Allerdings sind nicht alle Klebsysteme für diese Aufgabe geeignet. Klebstoffe mit Lösungsmittel greifen das Kartenmaterial an, während zweikomponentige Reaktionsklebstoffe nicht schnell genug aushärten.

Vielfach eingesetzt werden flüssige Klebstoffe auf Cyanacrylat-Basis ( Methyl- bis Butylester ), weil diese bei Raumtemperatur schnell aushärten. Für Arbeitstakte unterhalb einer Sekunde, wie sie heute bereits in der Herstellung derartiger Karten gefordert werden, ist die Reaktionsgeschwindigkeit allerdings zu gering. Weiterhin bestehen Nachteile darin, daß durch wechselnde Luftfeuchtigkeit und durch die Polarität des Kartenmaterials eine Beeinflussung der Aushärtung nicht ausgeschlossen werden kann. Schließlich können Produktionsstörungen durch ungezieltes Aushärten des Klebstoffs im Bereich der Produktionslinie, z. B. ein Verstopfen der Auftragsdüsen, auftreten. Ebenfalls ungünstig ist das gelegentlich auftretende Ausquetschen von Klebstoff zwischen Modul und Kartenmaterial. Darüber hinaus ist die entstehende sprödharte Klebefuge als nachteilig anzusehen, weil ein häufiges Biegen der Chipkarte zum Versagen der Verklebung führen kann.

Selbstklebende Systeme, wie sie in EP-A 521 502 beschrieben werden, erfüllen zumeist nicht die Anforderungen an die Festigkeit der Verklebung, so daß mit diesen hergestellte Datenträger oft nicht den an sie gestellten Ansprüchen bezüglich Einsatzsicherheit gerecht werden.

Auch die in EP-A 493 738 als Heißklebeband (17) gekennzeichneten filmförmigen Schmelzklebstoffe, die sogenannten Hotmelts, die z.B. als Ethylenvinylacetat ( EVA ) oder Styrolbutadien-Copolymer ( SBS ) bei Raumtemperatur eher plastisches Verhalten aufweisen, werden nicht allen an sie gestellten Aufforderungen beim Verkleben des Moduls mit dem Kartenkörper gerecht, insbesondere erreichen sie nicht die benötigte Wärmefestigkeit.

Aus der JP 08 250 522 A ist eine Klebfolie bekannt, mittels derer Chips auf einen Leiterrahmen verklebt werden, um ein Halbleiterelement herzustellen. Die Klebfolie setzt sich dabei zusammen aus Epoxid-Harz, Härter, thermoplastischem Harz und Isolationspuder. Das Verpressen der Chips erfolgt bei Temperaturen von 120°C bis 300 °C und für mehrere Minuten.

Die bekannten Datenträger und deren Herstellung weisen demnach für die Praxis bedeutsame Nachteile auf. Bei mit herkömmlichen Klebem hergestellten Datenträgem ist die Verarbeitungsgeschwindigkeit für sehr große Stückzahlen zu gering. Aber auch die thermoaktivierbaren, reaktiven Klebefolien sind nicht ohne Einschränkung einsetzbar. Derartige Klebfolien, die mit einer Dicke von ungefähr 70 µm im Handel zu beziehen sind, verlangen beim Heißverpressen eine Temperatur von mindestens 120 °C, um zu einer verläßlichen Verklebung zu führen. Bei einer derartigen, auch kurzzeitigen Temperaturbeanspruchung werden die aus Kunststoff gefertigten Datenträger aber leicht beschädigt. Ferner treten im Boden der Datenträger Verformungen auf, die die spätere reibungslose Verwendung der Datenträger beeinträchtigen können.

Der Erfindung liegt nun die Aufgabe zugrunde, eine Klebstoffolie zu schaffen, die selbst und bei ihrer Verwendung die Nachteile des Standes der Technik nicht oder zumindest nicht in dem Umfang aufweist.

Gelöst wird diese Aufgabe durch eine Klebstoffolie, wie sie in den Patentansprüchen näher gekennzeichnet ist.

Thermoplastische Klebstoffolien auf der Basis von Polymeren wie Polyurethanen, Polyestern oder Polyamiden genügen den an sie bei der Verklebung von Modulen mit dem Kartenkörper gestellten Anforderungen bereits zu einem großen Teil. Hohe Kohäsion und spezifische Haftung auf Kunststoffen bewirken hohe Verbundfestigkeit. Weiterhin gewährleistet die bei Raumtemperatur dominierende hohe Elastizität gute Biegefestigkeit.

Überraschend gelang es nun, durch Zusätze von nichtreaktiven Harzen und/oder reaktiven Harz/Härter-Systemen die hohen Aktivierungstemperaturen der unmodifizierten Polymere zu senken, ohne die guten Verklebungseigenschaften zu beeinträchtigen.

Die bevorzugte Ausführungsform der erfindungsgemäßen thermoplastischen Klebstoffolie basiert auf einem thermoplastischen Polyurethan. Thermoplastische Polyurethane (TPU) sind als Reaktionsprodukte aus Polyester- oder Polyetherpolyolen und organischen Diisocyananten wie Diphenylmethandiisocyanat bekannt. Sie sind aus überwiegend linearen Makromolekülen aufgebaut. Solche Produkte sind zumeist in Form elastischer Granulate im Handel erhältlich, z. B. von der Bayer AG unter dem Handelsnamen "Desmocoll".

Mittels Extrusion durch eine Breitschlitzdüse lassen sich thermoplastische Polyurethane zu einer Folie verarbeiten. Eine andere bekannte Möglichkeit besteht in der Ausbreitung von TPU-Lösungen auf silikonisiertem Papier mit anschließender Trocknung, wobei beispielsweise Ethylacetat als Lösungsmittel eingesetzt werden kann.
Die Erweichungstemperaturen dieser TPU-Folien liegen in ähnlicher Größenordnung wie die der üblichen Materialien, aus denen die Kartenkörper hergestellt werden. Eine Verwendung als Klebstoffolie zum Implantieren der Module ist daher nur eingeschränkt möglich, denn beim Herstellungsprozeß muß der Preßstempel des Klebautomaten so hoch erhitzt werden, daß das Kartenmaterial mitverformt wird. Solch verformte Karten sind aber in der Regel für den späteren Gebrauch nicht geeignet.

Durch Kombination von TPU mit ausgewählten verträglichen Harzen kann die Erweichungstemperatur der Klebstoffolie ausreichend gesenkt werden, so daß eine Verformung des Kartenkörpers während des Herstellungsprozeßes ausgeschlossen ist. Parallel dazu tritt sogar eine Erhöhung der Adhäsion auf. Als geeignete Harze haben sich beispielsweise bestimmte Kolophonium-, Kohlenwasserstoff- und Cumaronharze erwiesen.

Alternativ oder ergänzend dazu kann die Reduzierung der Erweichungstemperatur der Klebstoffolie durch die Kombination von TPU mit ausgewählten Epoxidharzen auf der Basis von Bisphenol A und/oder F und einem latenten Härter erreicht werden. Eine Klebstoffolie aus einem derartigen System erlaubt ein Nachhärten der Klebfuge, entweder allmählich bei Raumtemperatur ohne jeden weiteren äußeren Eingriff oder kurzzeitig durch eine gezielte Temperierung der Karten nach der Herstellung. Auf diese Weise kann ein späteres, zerstörungsfreies Herauslösen des Chips in krimineller Absicht, z. B. unter Verwendung eines üblichen Bügeleisens, unterbunden werden.

Die erfindungsgemäßen Klebstoffolien zeichnen sich durch eine Reihe von Vorteilen aus:
- Sie besitzen eine hohe Kohäsion und Elastizität bei Raumtemperatur.
- Sie zeigen eine hohe Adhäsion auf den üblichen Chip-Kartenmaterialien wie beispielsweise PVC, PC, PET oder ABS.
- Sie sind aktivierbar unterhalb der Erweichungstemperatur der Kartenmaterialien.

Darüber hinaus weisen Chipkarten, deren Module mit einer erfindungsgemäßen Klebstoffolie eingeklebt werden, eine besonders hohe Biegefestigkeit auf. Dies beweist die Durchführung eines Dauerbiegetests unter ständigem Lastwechsel nach DIN EN 20 178.

Im folgenden soll die erfindungsgemäße Klebstoffolie mit Hilfe von Beispielen näher beschrieben werden, ohne die Erfindung damit unnötig einschränken zu wollen.

Die aufgeführten beispielhaften Zusammensetzungen für die Klebstoffolie lassen sich durch Veränderung von Rohstoffart und -anteil in weitem Rahmen variieren. Ebenso können weitere Produkteigenschaften wie beispielsweise Farbe, thermische oder elektrische Leitfähigkeit durch gezielte Zusätze von Farbstoffen, mineralischen bzw. organischen Füllstoffen und/oder Kohlenstoff- bzw. Metallpulvern erzielt werden.

Die nachstehend beschriebenen Produkte können sowohl lösungsmittelfrei als auch aus Lösung hergestellt werden.

Bei der lösungsmittelfreien Herstellung werden die einzelnen Bestandteile im Kneter bei 130 °C vorgemischt und anschließend bei 110 bis 120 °C über eine Breitbandschlitzdüse zu einer Folie extrudiert und auf Trennpapier aufgewickelt. Diese Herstellungsweise ist für dickere Folien von 50 bis 500 µm und darüber geeignet.

Bei der Herstellung der Klebstoffolie aus Lösung werden die Bestandteile in einem Lösungsmittelgemisch aus 30 Gew.-% Ethylacetat, 40 Gew.-% Aceton und 30 Gew.-% Benzin gelöst, vorzugsweise mit einem Feststoffanteil von ungefähr 40 Gew.-%. Diese Lösung wird mittels Rakel in definierter Schichtstärke auf Silikonpapier aufgebracht und getrocknet. Das Verfahren eignet sich zur Herstellung dünner Klebstoffolien mit Trockenschichtdicken zwischen 10 und 100 µm.

### Beispiel 1

| | Handelsbezeichnung | Anteil in Gew.-% |
|---|---|---|
| Thermoplast. PU ( TPU ) | Desmocoll 400 ( Bayer AG ) | 70 |
| Kolophoniumharz | Harz 731 D ( Abieta Chemie ) | 18 |
| Kohlenwasserstoffharz | Harz KW 20 ( Rütgers VfT ) | 11,5 |
| SiO₂, amorph | Aerosil 200 ( Degussa ) | 0,5 |

### Beispiel 2

| | Handelsbezeichnung | Anteil in Gew.-% |
|---|---|---|
| Thermoplast. PU ( TPU ) | Desmocoll 540 ( Bayer AG ) | 65 |
| Epoxidharz ( Bisphenol A ) | Rütapox 0164 ( Bakelite AG ) | 30 |
| Dicyandiamid | Dyhard 100 S ( SKW Trostberg ) | 3 |
| SiO₂, amorph | Aerosil R 202 ( Degussa ) | 2 |

Bei einer Chipkarte, die mit einer Klebstoffolie nach Beispiel 2 hergestellt wird, ist ein nachträgliches, mißbräuchliches Entfernen des Chips kaum mehr möglich, wenn diese nach dem eigentlichen Herstellungsprozeß noch für 10 Stunden bei einer Temperatur von circa 90 °C gelagert wird.

## Patentansprüche

1. Thermoplastische Klebstoffolie zum Implantieren von elektrischen Modulen in einen Kartenkörper, der mit einer Aussparung versehen ist, in die ein elektronisches Modul anzuordnen ist, das auf der ersten Seite mehrere Kontaktflächen und auf der der ersten Seite gegenüberliegenden zweiten Seite einen IC-Baustein aufweist, dessen Anschlußpunkte über elektrische Leiter mit den Kontaktflächen verbunden sind, wobei die Klebstoffolie zur Verbindung der zweiten Seite des Moduls mit dem Kartenkörper dient, dadurch gekennzeichnet, daß die Klebstoffolie die Kombination folgender Bestandteile, nämlich
i) eines thermoplastischen Polymers mit einem Anteil von mindestens 40 Gew.-%, und dazu
ii) eines oder mehrerer klebrigmachender Harze mit einem Anteil von 5 bis 50 Gew.-% und/oder von
iii) Epoxidharzen mit Härtern mit einem Anteil von 5 bis 40 Gew.-%,
aufweist.

2. Thermoplastische Klebstoffolie nach Anspruch 1, dadurch gekennzeichnet, daß es sich beim thermoplastischen Polymer um ein thermoplastisches Polyurethan, ein Polyester oder ein Polyamid handelt.

3. Thermoplastische Klebstoffolie nach Anspruch 1, dadurch gekennzeichnet, daß die Klebstoffolie mit einem oder mehreren Additiven abgemischt ist.

4. Thermoplastische Klebstoffolie nach Anspruch 1, dadurch gekennzeichnet, daß die Klebstoffolie eine Dicke von 10 bis 100 µm aufweist.

5. Thermoplastische Klebstoffolie nach Anspruch 1, dadurch gekennzeichnet, daß die Klebstoffolie für ein Heißverpressen bei Temperaturen unter 120 °C, insbesondere bei 80 bis 100 °C, geeignet ist.

6. Thermoplastische Klebstoffolie nach Anspruch 1, dadurch gekennzeichnet, daß die Klebstoffolie als Stanzling vorliegt.

7. Verwendung einer thermoplastischen Klebstoffolie nach einem der Ansprüche 1 bis 6 zum Implantieren von elektrischen Modulen in einen Kartenkörper, der mit einer Aussparung versehen ist, in die ein elektronisches Modul anzuordnen ist, das auf der ersten Seite mehrere Kontaktflächen und auf der der ersten Seite gegenüberliegenden zweiten Seite einen IC-Baustein aufweist, dessen Anschlußpunkte über elektrische Leiter mit den Kontaktflächen verbunden sind, wobei die Klebstoffolie zur Verbindung der zweiten Seite des Moduls mit dem Kartenkörper dient.

## Claims

1. Thermoplastic adhesive film for implanting electrical modules in a card base which is provided with a recess in which an electronic module is to be disposed, the said module having on the first side a plurality of contact areas and having on the second side, which is opposite to the first side, an IC chip whose terminals are connected by electrical conductors to the contact areas, the adhesive film being used to join the second side of the module to the card base, characterized in that the adhesive film exhibits the combination of the following constituents, namely
i) a thermoplastic polymer with a proportion of at least 40% by weight, plus
ii) one or more tackifier resins with a proportion of from 5 to 50% by weight, and/or
iii) epoxy resins with curing agents, with a proportion of from 5 to 40% by weight.

2. Thermoplastic adhesive film according to Claim 1, characterized in that the thermoplastic polymer is a thermoplastic polyurethane, a polyester or a polyamide.

3. Thermoplastic adhesive film according to Claim 1, characterized in that the adhesive film is blended with one or more additives.

4. Thermoplastic adhesive film according to Claim 1, characterized in that the adhesive film has a thickness of from 10 to 100 µm.

5. Thermoplastic adhesive film according to Claim 1, characterized in that the adhesive film is suitable for hot pressing at temperatures below 120 °C, in particular at from 80 to 100 °C.

6. Thermoplastic adhesive film according to Claim 1, characterized in that the adhesive film is in the form of a punched component.

7. Use of a thermoplastic adhesive film according to one of Claims 1 to 6 for implanting electrical modules in a card base which is provided with a recess in which an electronic module is to be disposed, the said module having on the first side a plurality of contact areas and having on the second side, which is opposite to the first side, an IC chip whose terminals are connected by electrical conductors to the contact areas, the adhesive film being used to join the second side of the module to the card base.

## Revendications

1. Feuille adhésive thermoplastique destinée à l'implantation de modules électriques dans un corps de carte, qui est pourvu d'un évidement, dans lequel on peut disposer un module électronique, qui présente, sur sa première face, plusieurs surfaces de contact et, sur la deuxième face opposée à la première, un élément Cl, dont les points de connexion sont reliés par l'intermédiaire de conducteurs électriques aux surfaces de contact, la feuille adhésive servant à la connexion de la deuxième face du module avec le corps de carte, caractérisée en ce que la feuille adhésive présente la combinaison des constituants suivants, à savoir
i) d'un polymère thermoplastique ayant une proportion d'au moins 40 % en poids et, en plus,
ii) d'une ou de plusieurs résines à bon pouvoir de pégosité, ayant une proportion de 5 à 50 % en poids et/ou
iii) de résines époxydes à agents durcisseurs ayant une proportion de 5 à 40 % en poids.

2. Feuille adhésive thermoplastique selon la revendication 1, caractérisée en ce qu'il s'agit, dans le cas du polymère thermoplastique, d'un polyuréthanne, d'un polyester ou d'un polyamide thermoplastique.

3. Feuille adhésive thermoplastique selon la revendication 1, caractérisée en ce que la feuille adhésive est mélangée à un ou plusieurs additifs.

4. Feuille adhésive thermoplastique selon la revendication 1, caractérisée en ce que la feuille adhésive présente une épaisseur de 10 à 100 microns.

5. Feuille adhésive thermoplastique selon la revendication 1, caractérisée en ce que la feuille adhésive est appropriée à une compression à chaud à des températures de moins de 120°C, en particulier de 80 à 100°C.

6. Feuille adhésive thermoplastique selon la revendication 1, caractérisée en ce que la feuille adhésive existe en tant que produit d'estampage.

7. Utilisation d'une feuille adhésive thermoplastique selon l'une quelconque des revendications 1 à 6, en vue de l'implantation de modules électriques dans un corps de carte, qui est pourvu d'un évidement, dans lequel on peut disposer un module électronique, qui présente, sur sa première face, plusieurs surfaces de contact et, sur la deuxième face opposée à la première, un élément Cl, dont les points de connexion sont reliés par l'intermédiaire de conducteurs électriques aux surfaces de contact, la feuille adhésive servant à la connexion de la deuxième face du module avec le corps de carte.
